# EUROPEAN PATENT SPECIFICATION

(11) **EP 3 460 624 B1**
(45) Date of publication and mention of the grant of the patent: **24.08.2022**
(21) Application number: 16902335.5
(22) Date of filing: 16.05.2016
(51) Int. Cl.: G06F 1/18, G06F 1/20, H05K 7/02, H05K 7/20, H05K 1/14

(54) **LIQUID IMMERSION COOLED ELECTRONIC DEVICE**
DURCH FLÜSSIGKEITSIMMERSION GEKÜHLTE ELEKTRONISCHE VORRICHTUNG
DISPOSITIF ÉLECTRONIQUE REFROIDI PAR IMMERSION DANS UN LIQUIDE

(43) Date of publication of application: 27.03.2019
(73) Proprietor: Exascaler Inc., Tokyo 101-0052 (JP)
(72) Inventor: SAITO, Motoaki, Tokyo 101-0062 (JP)
(74) Representative: Goddar, Heinz J.
(86) International application number: PCT/JP2016/064532
(87) International publication number: WO 2017/199315

(56) References cited:
- JP-A- 2008 205 402
- JP-A- 2015 076 113
- JP-A- 2015 507 233
- JP-A- 2016 046 431
- US-A1- 2014 216 711

## Description

### Technical Field

The present invention relates to an electronic device. More specifically, the present invention relates to an electronic device immersed in the coolant filled in a cooling apparatus so as to be directly cooled. The electronic device described in the specification is required to exhibit super-high performance and stable operations while generating high heating value such as supercomputer and data center. However, it is not limited to those described above.

### Background Art

Power consumption is one of the essential factors to determine the performance limit of the recent supercomputer. The importance of study on saving power consumed by the supercomputer has been widely recognized. That is, the speed performance per power consumption (Flops/W) is one of indexes for evaluating the supercomputer. The power for cooling operations accounts for approximately 45 % of the power consumption of the entire data center. Reduction in the power consumption by improving cooling efficiency has been increasingly demanded.

Conventionally, the process for cooling the supercomputer and the data center has been performed through two different methods, that is, air cooling method and liquid cooling method. In general, the cooling efficiency of the liquid cooling method is better than that of the air cooling method attributable to superior heat transfer performance to that of air. Especially, in comparison with the liquid immersion cooling system using synthetic oil, the liquid immersion cooling system using fluorocarbon-based coolant has received much attention because of the advantage in regards to the maintenance work for the electronic device (specifically, for example, adjustment, inspection, repair, replacement, extension and the like),

The inventor has already developed the compact liquid immersion cooling apparatus with excellent cooling efficiency suitable for the supercomputer of small-scale liquid immersion cooling type. Such apparatus has been applied to the compact supercomputer "Suiren" installed and operated in the high-energy accelerator research organization (Non-patent Literature 1) .

The inventor has also proposed the improved liquid immersion cooling apparatus configured to allow substantial improvement in packaging density of the electronic devices subjected to the liquid immersion cooling (Non-patent Literature 2).

### Citation List

Non-Patent Literature 1: "Liquid immersion cooling compact supercomputer "ExaScaler-1" succeeded in measurement of the value corresponding to the world highest level of the latest supercomputer power consumption performance ranking "Green500" resulting from the performance improvement by 25 % or higher" March 31, 2015, Press Release, ExaScaler Inc., et al., URL:http://exascaler.co.jp/wp-content/uploads/2015/03/20150331.pdf

Non-Patent Literature 2: "Innovation of Semiconductor, Cooling, Connection, Aiming at Exa-grade High-performance Machine - Part I", July 2015 issue of Nikkei Electronics, pp. 99-105, June 20, 2015, published by Nikkei Business Publications, Inc.

JP 2008 205 402 A discloses an air-cooled type module. Heat conductors made of copper of aluminum are contacted to memory modules so as to radiate generated heat in a space.

US 2014/216711 A1 discloses that, among an immersion server, a motherboard assembly is immersed in a cooling liquid, whereas storage devices are air cooled by rising vapor generated as the cooling liquid a vaporize.

### Summary of Invention

### Technical Problem

There has been required to develop an electronic device applied to the liquid immersion cooling apparatus, which is newly configured to allow a plurality of processors to carry out arithmetic operations as prime objects by installing more units of processors in a limited volume so as to further improve processing capabilities and packaging density.

There has been required to develop an electronic device applied to the liquid immersion cooling apparatus, which is newly configured to mainly serve as a memory using more units of storage devices installed in the limited volume so as to further improve storing capacity and packaging density.

There has been required to develop an electronic device applied to the liquid immersion cooling apparatus, which is newly configured to serve mainly as a memory using a plurality of storage devices so as to further improve packaging density while exhibiting maintainability of the electronic device. Solution to Problem

The present invention provides a cooling apparatus according to claim 1.

In a preferred embodiment of the present invention, the liquid immersion cooling apparatus includes a cooling tank with an open space defined by a bottom wall and side walls, the arranged housing parts formed by dividing the open space using a plurality of internal partition walls in the cooling tank, and an inflow opening and an outflow opening for the coolant. The inflow opening is formed in a bottom part or a side surface of each of the housing parts, and the outflow opening is formed around a surface of the coolant circulating in the respective housing parts. The electronic device includes a base board, a plurality of storage substrates to be arranged on at least one surface of the base board, a backplane including a plurality of connectors for electric connection of the respective storage substrates, which is mounted orthogonally onto the one surface of the base board, and a plurality of flash storage units mounted on the respective storage substrates. The flash storage units are arranged on a surface parallel to at least one surface of each of the storage substrates so as to be adjacent one another in a width or a length direction, or in both the width and the length directions of the flash storage unit.

In a preferred embodiment of the electronic device according to the aspect of the present invention, the flash storage unit may be an M.2 SSD or an mSATASSD.

In a preferred embodiment of the electronic device according to the aspect of the present invention, a plurality of flash storage connectors are arranged on the one surface of the storage substrate; and each electric contact of the flash storage units to be inserted into each of the flash storage connectors.

In a preferred embodiment of the electronic device according to the aspect of the present invention, the storage substrates are further arranged on a surface opposite the one surface of the base board; and
the backplane further includes a plurality of connectors for electric connection of the storage substrates arranged on the surface opposite the one surface of the base board.

The cooling tank having the "open space" described in the specification includes the cooling tank with a simple sealing structure sufficient to secure maintainability of the electronic device. The simple sealing structure refers to the one that allows the top plate for closing the open space of the cooling tank to be disposed on the opening of the cooling tank, or the one that allows the top plate to be detachably mounted via the packing or the like.

The above-described and other objects and advantages will be clearly understood in reference to the following explanations of the embodiments. It is to be understood that the embodiments are described for exemplifying purposes, and therefore, the present invention is not limited to those described herein.

### Brief Description of Drawings

Figure 1 is a front view of an electronic device.
Figure 2 is a plan view of a multiprocessor substrate installed in the electronic device.
Figure 3 is a side view of the electronic device.
Figure 4 is a plan view of the electronic device.
Figure 5 is a front view of the electronic device.
Figure 6A shows an example of a storage substrate contained in the electronic device, while showing (a) as a plan view and (b) as a sectional view.
Figure 6B is a partially enlarged sectional view of an example of the storage substrate contained in the electronic device.
Figure 7 is a side view of the electronic device.
Figure 8 is a partial assembly diagram of the electronic device.
Figure 9 is a view showing another example of a backplane contained in the electronic device.
Figure 10A is a plan view showing another example of a storage substrate contained in the electronic device.
Figure 10B is a partially enlarged sectional view showing another example of the storage substrate contained in the electronic device.
Figure 11A is a plan view showing another example of the storage substrate contained in the electronic device.
Fig. 11B is a partially enlarged sectional view showing another example of the storage substrate contained in the electronic device.
Figure 12 is a perspective view of an overall structure of a liquid immersion cooling apparatus.
Figure 13 is a longitudinal sectional view of the liquid immersion cooling apparatus.
Figure 14 is a plan view of the liquid immersion cooling apparatus.
Figure 15 is a perspective view of a structure of an essential part of the liquid immersion cooling apparatus.
Figure 16 is a lateral sectional view of a structure of the essential part of the liquid immersion cooling apparatus.
Figure 17 is a longitudinal sectional view of an example of a lifting mechanism of the liquid immersion cooling apparatus.
Figure 18 is a view schematically showing a structure of a cooling system.

### Description of Embodiments

Several electronic devices will be described in detail referring to the drawings.

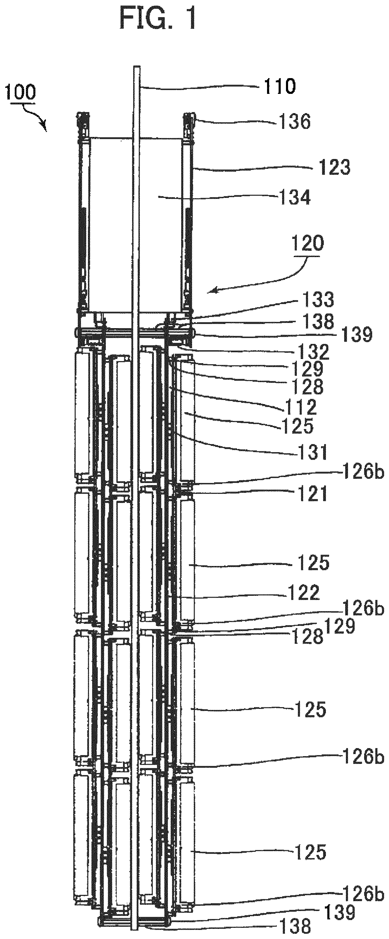

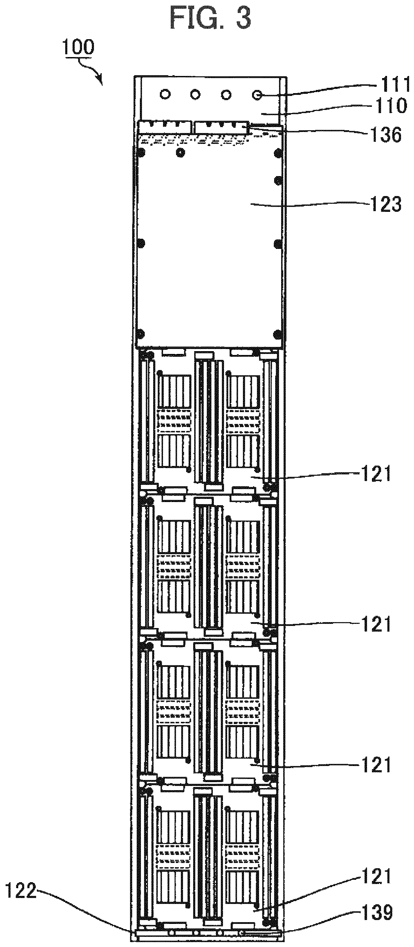

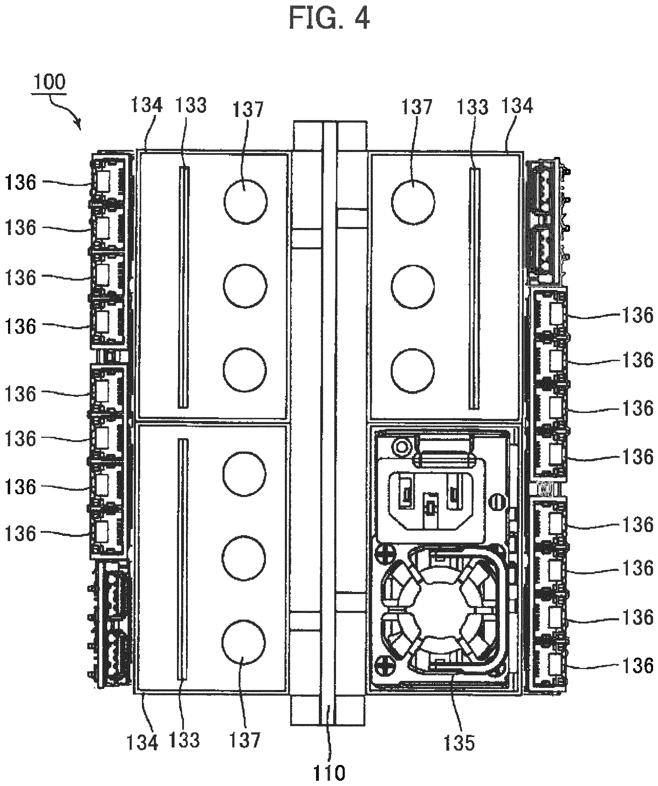

Referring to Figures 1 to 4, an electronic device 100 will be described. Figure 1 is a front view of the electronic device 100. Figure 3 is a side view, and Figure 4 is a plan view of the electronic device. The electronic device 100 is immersed in the coolant filled in a cooling apparatus to be described later so as to be directly cooled. It is configured to be housed in each of a plurality of housing parts of the cooling apparatus. The electronic device 100 includes a base board 110 that is retained with a pair of board retainers to be described later, and a substrate group 120 attached to a first surface of the base board 110, and a second surface opposite the first surface, respectively.

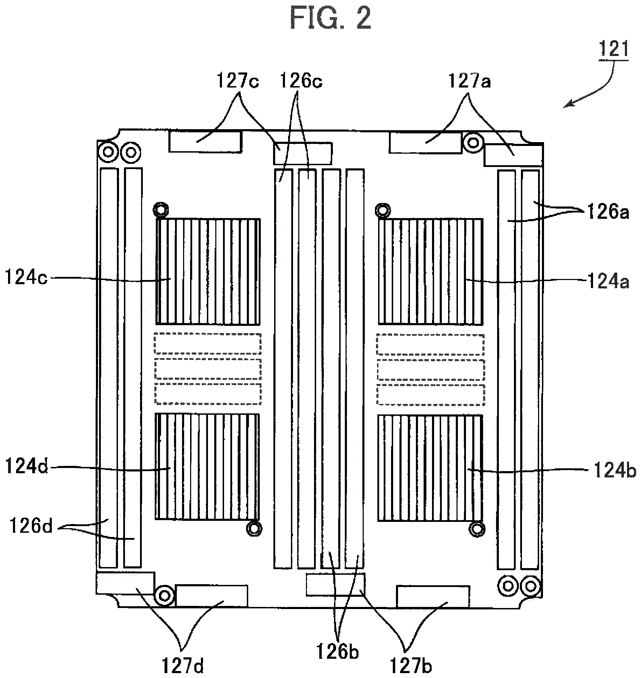

In the illustrated example, the substrate group 120 constitutes four first circuit boards 121. Each of the first circuit boards 121 includes four processors 124a, 124b, 124c, 124d, and eight sockets 126a, 126b, 126c, 126d for main memories, which are mounted on one surface of the first circuit board 121 as Figure 2 shows. Each of the main memories 125 has its electric contact inserted into the corresponding socket so that the memory is mounted on one surface of the first circuit board 121. In this case, eight sockets for the main memories are arranged as shown in Figure 2 so that the main memories 125 are arranged to partition the one surface of the first circuit board 121 into two regions in a width direction. In each of the two regions, two processors (processors 124a, 124b are disposed on the first region, and processors 124c, 124d are disposed on the second region) are arranged in the substrate length direction of the substrate on a main memory 125. The number of the regions may be set to the value equal to 2 or more. Preferably, the length of the processor in the direction of the substrate length of the main memory is set to be equal to or less than 1/2 of the substrate length of the main memory. For example, the semiconductor device of system on-chip type design (for example, Intel Xeon processor D product family of Intel Corporation) may be employed for the processor. The use of the ultra-low memory module (for example, general purpose 326B DDR4 (Double-Data-Rate4) VLP DIMM (very low profile Dual Inline Memory Module) as the main memory makes it possible to actualize the above-described layout of the semiconductor device.

The main memory 125 will be inserted into the two sockets 126a adjacent to the processor 124a, and are associated with the processor 124a through communication via a bus. The above-described correlation applies to those between the other processors 124b, 124c, 124d and the main memories 125 to be inserted into the other sockets 126b, 126c, 126d which are adjacent to those processors, respectively. Power from a power unit to be described later is supplied to those processors and the main memories through voltage conversion circuits (DC/DC converter) 127a, 127b, 127c, 127d. Each number of the first circuit boards 121 of the substrate group 120, the processors 124a, 124b, 124c, 124d of the respective first circuit boards, and the main memories 125 is set for exemplifying purpose. Especially, each number of the processors and the main memories may be set to 4 or more.

The substrate group 120 further includes second circuit boards 122. The second circuit board 122 performs signal transmission between the first circuit board 121 and a third circuit board to be described later, and distribution of a DC power supply from a power unit 135 to be described later to the respective first circuit boards. The component of the second circuit board 122 may include the PCI Express bus, and the bus switch unit.

The second circuit board 122 includes a first connector 131 for electrically connecting the first circuit board 121 and the second circuit board 122, and a flow channel 112 formed in a gap between the surface opposite the one surface of the first circuit substrate 121 and one surface of the second circuit board 122, which faces the surface opposite the first circuit substrate. The substrate group 120 includes a plurality of spacers 128 for retaining the gap, and a plurality of screws 129. Each of the screws 129 pierces through the first circuit board 121, the second circuit board 122, and the spacers 128, respectively for fastening.

The above-structured first circuit board 121 on which the processors 124a, 124b, 124c, 124d, and the main memories 125 are mounted may be detachably attached to the second circuit board 122. It is possible to subject the first circuit board 121 including the processors 124a, 124b, 124c, 124d, and the main memories 125 to adjustment, inspection, repair, replacement, extension, and the like separately from the second circuit board 122, resulting in significantly improved maintainability.

The main memories 125 are arranged so as to divide the one surface of the first circuit board 121 into two regions in the width direction. Two processors for each of the two regions (processors 124a, 124b for the first region, processors 124c, 124d for the second region) are arranged in the substrate length direction of the main memory 125 so that the coolant circulating in the regions divided by the main memories 125 takes heat from the respective surfaces of the arranged processors 124a, 124b, 124c, 124d immediately and efficiently. It is possible to thermally connect the heat radiation member (for example, heat sink) to the surfaces of the respective processors 124a, 124b, 124c, 124d for the purpose of improving the cooling efficiency of the processor.

The flow channel 112 between the first circuit board 121 and the second circuit board 122 allows the coolant circulating through the flow channel 112 to take heat immediately and efficiently from the back surface of the first circuit board 121 on which the processors are installed, resulting in improved cooling efficiency. In the generally employed apparatus of air-cooled type, the device layout of the processors as shown in Figure 2 cannot be realized.The use of the above-described heat taking function of the circulating coolant results in the significantly excellent cooling efficiency of the processors. Therefore, even if 4 or more processors are installed in the relatively narrow region with high density, stable operations of the processors and the electronic device 100 are secured. In accordance with the structure of the electronic device 100, the processor of system on-chip type design (16 cores) of Intel Xeon processor D product family produced by Intel Corporation, and two units of general purpose 32GB DDR4 VLP DIMM are combined into one set. The first circuit board is constituted by the thus structured four sets. The controller of Intel Ethernet (trademark) multi-host controller FM1000 family is operated for connecting 16 units of the first circuit boards. This makes it possible to realize ultra-high density mount of 1024 processors (16,384 cores) for the single unit of the electronic device 100.

Each of the first circuit boards 121 includes four processors 124a, 124b, 124c, 124d which are mounted on one surface of the first circuit board 121 as well as eight sockets 126a, 126b, 126c, 126d for the main memory. The first circuit board 121 may be configured into a minimum structure which includes two processors and a plurality of main memories disposed at both sides of the processors so that the two processors are arranged in the substrate length direction of the main memory. The length of each of the processors in the substrate length direction of the main memory is set to be equal to or less than 1/2 of the substrate length of the main memory. The above-described structure allows the coolant circulating in the regions divided with the main memories to take heat from the respective surfaces of the 2 arranged processors immediately and efficiently.

In the case that the single substrate group 120 is disposed on the first surface and the second surface of the base board 110 of the electronic device 100, respectively, it is preferable to make the external shape of a connected body of the base board 110 and the two substrate groups 120 similar to the internal shape of each of the housing parts of the cooling apparatus to be described below. Preferably, the external shape of the connected body is a rectangular parallelepiped, for example, as shown in the drawing.

Referring to the illustrated example, each of the substrate groups 120 includes a third circuit board 123. The third circuit board 123 includes four network controller chips (not shown), and eight network cable sockets 136, corresponding to the four first circuit boards 121, respectively. A second connector 132 serves to electrically connect the second circuit board 122 and the third circuit board 123.

Referring to the illustrated example, two slots 134 are attached to the first surface, and the second surface opposite the first surface of the base board 110, respectively above the substrate group 120 parallel to the base board 110. As Figure 4 shows, each of the four slots 134 is configured to house the power unit 135. The third circuit board 123 is fixed to the base board 110 using a screw 139 piercing through two spacers 138 and the second circuit board 122 so that the two slots 134 parallel to each other are interposed between the third circuit board 123 and the base board 110. Eight network cable sockets 136 are disposed in parallel on one side of the third circuit board 123 at each opening side of the two slots 134.

A socket of the third connector 133 for electrically connecting the power unit 135 and the second circuit board 122 is formed in the bottom of each slot. Three bottom holes 137 through which the coolant passes are formed in the bottom of each slot for immediately and efficiently taking heat from the power unit 135.

In this way, the base board 110 is combined with the third circuit board 123 having four network controller chips (not shown) corresponding to the four first circuit boards 121, respectively, and eight network cable sockets arranged on one side parallel to one another. The combination allows arrangement of the two slots 134 for the power unit 135 between the third circuit board 123 and the base board 110 at the position that cannot be obstructed by the network cable sockets 136. Conventionally, as the number of the first circuit boards 121 as the CPU units becomes large, it becomes more difficult to secure the space for accommodating two or more power units 135 because of increase in the network cable sockets. The use of the above-described arrangement ensures to solve the problem. That is, it is possible to impart redundancy of the power unit 135 for each of the substrate groups 120.

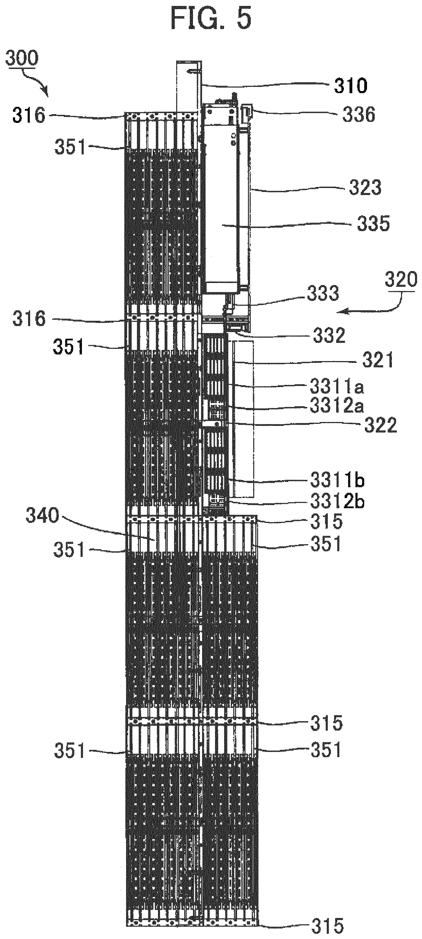

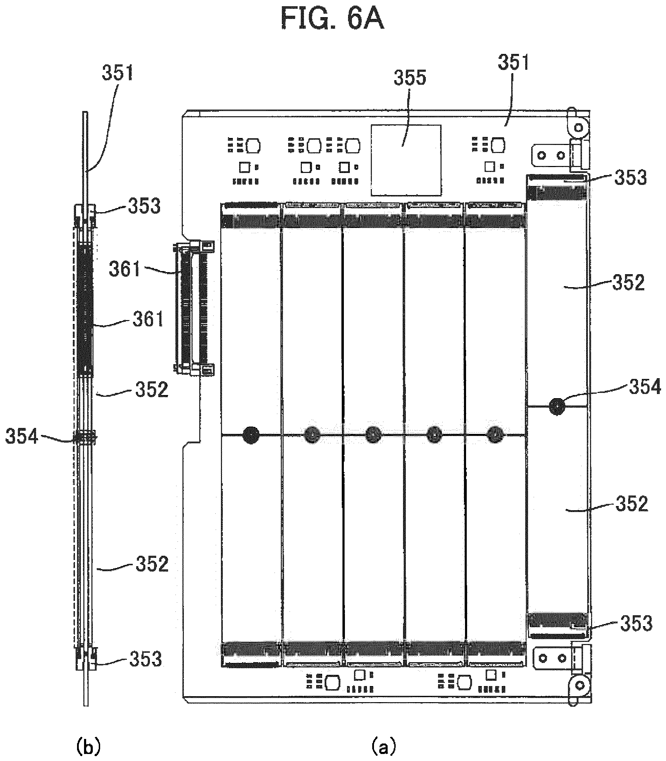

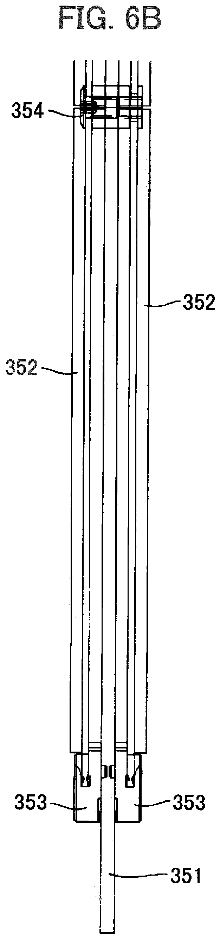

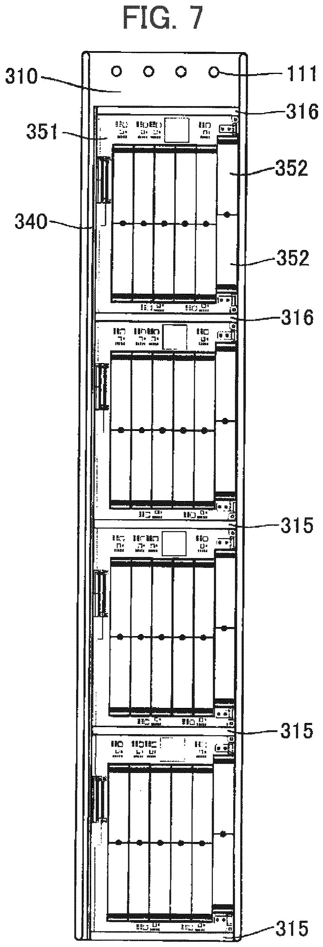

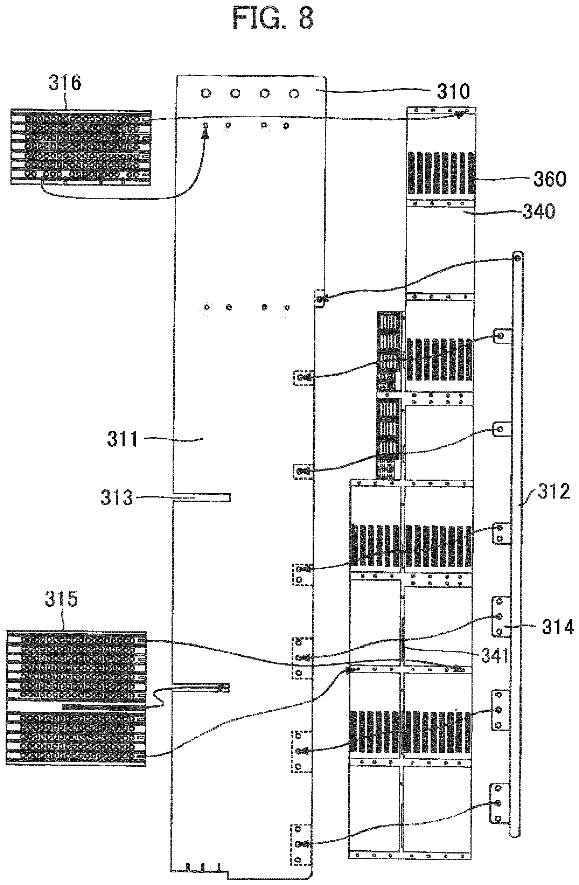

Another electronic device 300 will be described referring to Figures 5 to 8. Figure 5 is a front view of the electronic device 300. Figure 7 is a side view, and Figure 8 is a partial assembly diagram. Figure 6A shows an example of a storage substrate of the electronic device 300, while showing (a) as a plan view and (b) as a sectional view. Figure 6B is a partially enlarged view. The electronic device 300 is immersed in the coolant filled in a cooling apparatus to be described later so as to be directly cooled. It is configured to be housed in each of a plurality of housing parts of the cooling apparatus.

The electronic device 300 includes a base board 310 that is retained with a pair of board retainers provided for the housing part to be described later, and a plurality of storage substrates 351 which are disposed on the first surface of the base board 310, and the second surface opposite the first surface, respectively. Referring to the illustrated example, twelve storage substrates 351 are disposed on the first surface, and thirty-two storage substrates 351 are disposed on the second surface.

Likewise the electronic device 100 as shown in Figures 1 to 4, the electronic device 300 includes one or more substrate groups 320, each including a first circuit board 321, a second circuit board 322, and a third circuit board 323. Structures of the first circuit board 321, and the third circuit board 323 are similar to those of the first circuit board 121 and the third circuit board 123 of the electronic device 100 as shown in Figures 1 to 4, respectively except the following points. That is, the second circuit board 322 includes a set of signal connector 3311a and power connector 3312a, and a set of signal connector 3311b and power connector 3312b. Signals are transmitted between the third circuit board 323 and a backplane to be described later. The DC power is distributed from the power unit 335 to the backplane. Furthermore, structures of the processor (not shown), the main memory (not shown), the sockets (not shown), the power units 335 (2 sets), and the network cable sockets 336 (2 sets) are also similar to those of the electronic device 100, respectively. Accordingly, detailed explanations of those structures will be omitted.

In view of high-density mount of flash storage units, it is characterized by arrangement of the flash storage units mounted on the storage substrate as shown in Figures 6A, 6B, and 7.

Figure 6A is a view showing an example of the storage substrate, while showing (a) as a plan view and (b) as a sectional view. Referring to Figure 6A, the storage substrate 351 includes twelve flash storage units 352 on both surfaces, respectively, resulting in twenty-four (12 x 2) flash storage units 352. Especially, a plurality of flash storage connectors 353 are disposed on one surface and a surface opposite the one surface, respectively. The electric contacts each provided at one end of the flash storage unit 352 are inserted into the flash storage connector 353 so that 12 flash storage units 352 are arranged on the surface parallel to the one surface of the storage substrate 351, and on the surface parallel to the surface opposite the one surface, while being adjacent one another in the width direction or the length direction of the flash storage unit 352. The other end of each of the flash storage units 352 is fixed with a fastener 354. The above-described structure provides an extremely thin storage substrate 351 having twenty-four flash storage units mounted with high density. In addition to a RAID controller (not shown), an expander 355 (for example, SAS (Serial Attached SCSI) expander, SATA (Serial ATA) expander, PCI express expander) is mounted on the storage substrate 351 for securing connection to twenty-four flash storage units.

It is possible to use an M.2 SSD (Solid State Drive) or an mSATA SSD as the flash storage unit, but not limited thereto. It is possible to mount the flash storage unit while having the chip surface exposed, without requiring covering with a casing or the like. For example, the use of the SSD of M.2 2280 with thickness of 3.6 mm may actualize the card with thickness of 8.6 mm.

In view of implementing high-density mount of the flash storage substrates 351, it is characterized by the backplanes 340 each having a plurality of storage connectors 360 for electrically connecting the respective storage substrates 351, which are disposed on the first surface of the base board 310, and the second surface opposite the first surface in the direction orthogonal thereto as shown in Figure 8.

The base board 310 includes a primary member 311 and a secondary member 312. The primary member 311 includes a plurality of cuts 313 each formed in the width direction for fixing a plurality of support plates 315 that support the respective storage substrates to the primary member 311. Meanwhile, the secondary member 312 includes a plurality of pawls 314 which are inserted into a plurality of slits 341 formed in the backplane 340, respectively, and fixed to the primary member 311. The support plates 315, 316 include holes for passage of the coolant. In the illustrated example, there are three support plates 315 each having eight grooves, and there are two support plates 316 each having fourteen grooves so that the maximum of 44 (8 x 2 + 14 x 2) storage substrates 351 may be disposed. In addition to the RAID controller (not shown), the expander (for example, not shown SAS expander) is mounted on the backplane 340 for connection to the maximum of 44 storage substrates.

Upon attachment of the storage substrates 351, the backplane 340, and the substrate group 320 to the base board 310, the external shape of a connected body of the base board 310, the storage substrates 351, the backplane 340, and the substrate group 320 may be similar to each internal shape of the respective housing parts. The external shape of the connected body may be a rectangular parallelepiped as shown in Figure 7.

When the above-structured electronic device 300 is immersed in the coolant filled in the cooling apparatus so as to be directly cooled, the coolant circulating in the electronic device immediately and efficiently takes heat from the device on the storage substrate 351 (flash storage unit, expander, and the like), the device on the backplane 340 (expander, and the like), the device on the substrate group 320 (processor, network switch, and the like), and the power unit. Accordingly, it is possible to secure stable operations of the flash storage unit, the expander, and the electronic device 300 in spite of the high density mount. The respective storage substrates 351 may be detachably mounted onto the backplane 340. The respective flash storage units 352 may also be detachably mounted onto the storage substrates 351. It is possible to perform adjustment, inspection, repair, replacement, extension and the like for each of the flash storage units 352, or for each of the storage substrates 351 separately, resulting in significantly improved maintainability.

Referring to an example shown in Figure 8, the backplane 340 is provided as the single substrate. However, it is not easy to manufacture such long substrate including the wiring between the storage connector 360 and the signal connectors 3311a, 3311b, and the wiring between the storage connector 360 and the power connectors 3312a, 3312b. Furthermore, quality of such product as well as durability cannot be secured, resulting in the problem of cost increase. In order to solve the above-described problem, the backplane is constituted by combining a plurality of backplane units to be arranged in the longitudinal direction of the base board. Each of the backplane units may have both the signal connector and the power connector so as to be provided separately for each of the backplane units.

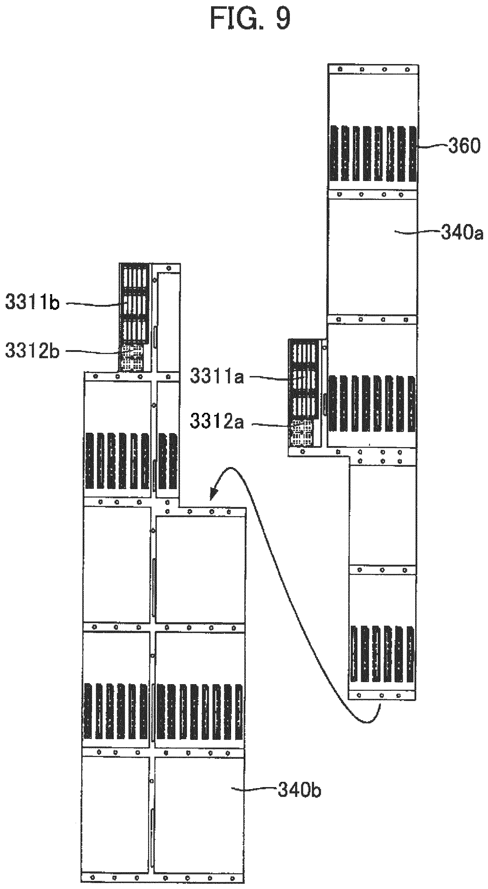

Figure 9 is a view showing another example of the backplane as described above. The backplane is constituted by combining two backplane units 340a, 340b which are arranged in the longitudinal direction of the base board 310. The backplane unit 340a includes the signal connector 3311a and the power connector 3312a, and the backplane unit 340b includes the signal connector 3311b and the power connector 3312b so that the signal connectors 3311a, 3311b, and the power connectors 3312a, 3312b are provided separately for each of the backplane units. The above-described structure facilitates simple manufacturing of the backplane while securing its quality, leading to the cost reduction.

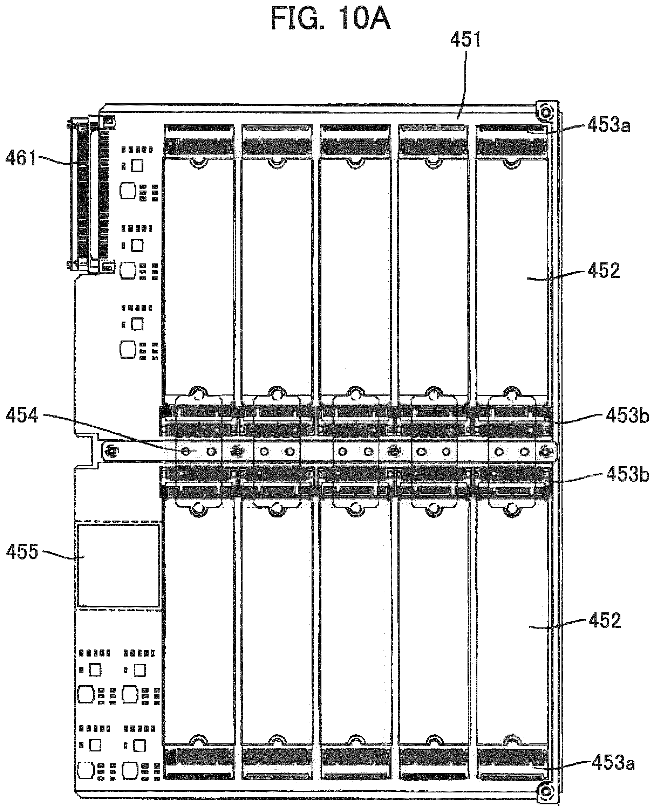

The above-described electronic device 300 ensures configuration of the storage substrate that allows far more flash storage units to be mounted. An explanation will be made referring to Figures 10A to 11B as an example that a total of forty flash storage units, twenty for one surface of the storage substrate, and twenty for the surface opposite the one surface are mounted.

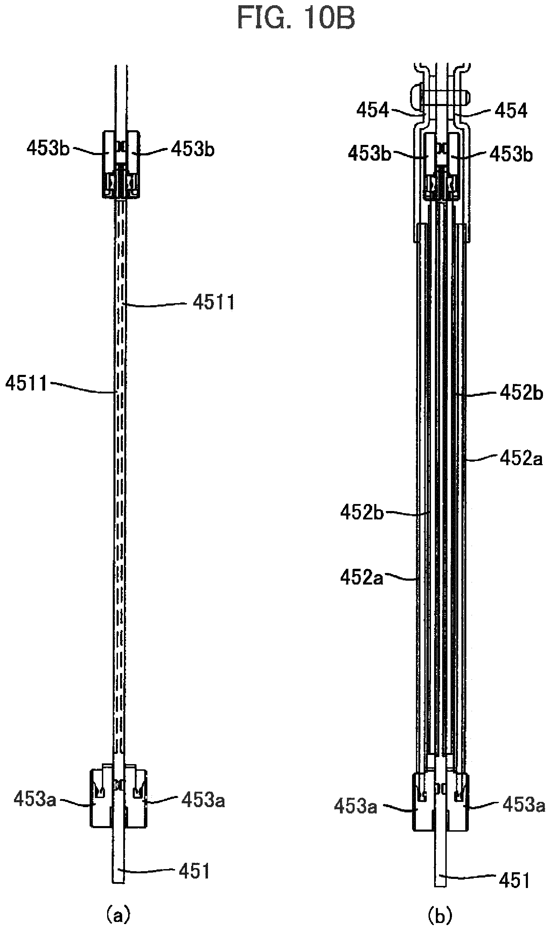

Figure 10A is a plan view showing another example of the storage substrate, and Figure 10B is a partially enlarged sectional view. Referring to Figures 10A and 10B, the 20 flash storage units 452 are mounted on one surface of the storage substrate 451, and the 20 flash storage units 452 are mounted on a surface opposite the one surface, respectively so that the 40 flash storage units are mounted on the substrate. Especially, two flash storage connectors 453a, 453b each different in height are disposed on one and opposite surfaces of the storage substrate 451 while facing each other. The electric contact at one end of the flash storage unit 452 is inserted into the two flash storage connectors 453a, 453b each different in height. Then the substrate is configured to arrange ten flash storage units 452 so as to be adjacent one another in a width or a length direction of the flash storage unit 452 both on two surfaces parallel to one surface of the storage substrate 451, and two surfaces parallel to the surface opposite the one surface. The storage substrate 451 has a groove 4511 that accommodates a part of the flash storage unit 452 having its end inserted into the low flash storage connector 453b. The other end of the flash storage unit 452 having its end inserted into the high flash storage connector 453a is fixed with a fastener 454. As a result, the ultra-thin storage substrate 451 may be provided having a total of forty flash storage units (10 units x 2 layers x 2) mounted with high density. In addition to the RAID controller (not shown), an expander 455 (for example, SAS expander, SATA expander, PCI express expander) is mounted on the storage substrate 451, which allows connection of the 40 flash storage units.

It is possible to use the M.2 SSD or the mSATA SSD as the flash storage unit, for example, but not limited thereto. It is possible to mount the flash storage unit while having the chip surface exposed, requiring no need of covering with a casing or the like. For example, the use of the SSD of M.2 2280 with thickness of 1.5 mm may realize the card with thickness of 6.9 mm.

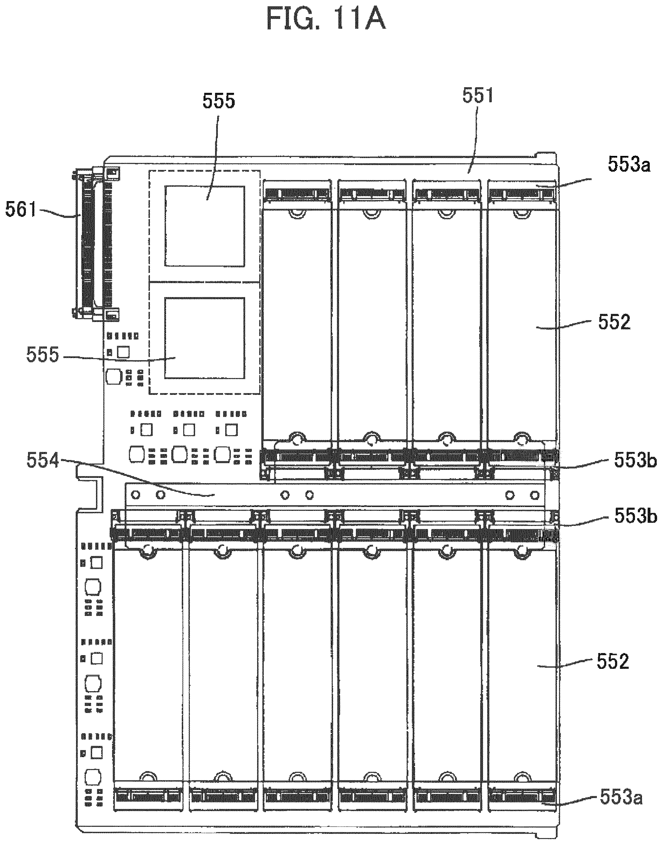

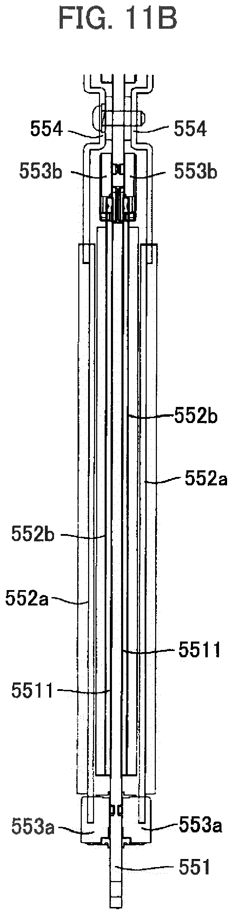

Figure 11A is a plan view of still another example of the storage substrate, and Figure 11B is a partially enlarged sectional view. Referring to Figures 11A and 11B, twenty flash storage units 552 are mounted on one surface of the storage substrate 551, and 20 flash storage units 552 are mounted on a surface opposite the one surface so that a total of forty flash storage units are mounted on the substrate. Likewise the example shown in Figures 10A and 10B, two flash storage connectors 553a, 553b each different in height are disposed on one and opposite surfaces of the storage substrate 551 while facing each other. The electric contact at one end of the flash storage unit 552 is inserted into the two flash storage connectors 553a, 553b each different in height. The substrate is configured to arrange the ten flash storage units 552 so as to be adjacent one another in the width or the length direction of the flash storage unit 552 both on two surfaces parallel to one surface of the storage substrate 551, and two surfaces parallel to the surface opposite the one surface. The storage substrate 551 has a groove 5511 that accommodates a part of the flash storage unit 552 having its end inserted into the low flash storage connector 553b. The other end of the flash storage unit 452 having its end inserted into the high flash storage connector 553a is fixed with a fastener 554. As a result, the ultra-thin storage substrate 551 may be provided having a total of forty flash storage units (10 units x 2 layers x 2) mounted with high density. In addition to the RAID controller (not shown), an expander 555 (for example, SAS expander, SATA expander, PCI express expander) is mounted on the storage substrate 551, which allows connection of the forty flash storage units.

Detailed explanation will be made with respect to preferred embodiments of the liquid immersion cooling apparatus configured to immerse the electronic device 100 described above, or the electronic device 300 in the coolant for direct cooling in reference to the drawings. The following explanation relates to the high density liquid immersion cooling apparatus configured to house total of sixteen units of the electronic devices 100 in the divided housing parts of the cooling tank so as to be cooled. The above explanation is made only for illustrative purpose, and an arbitrary number of the electronic devices may be housed in the high density liquid immersion cooling apparatus without limiting the structure of the electronic device to which the present invention is applied. As described below, the housing parts in the cooling tank may be configured to house not only the electronic devices of single type, but also those of different type, for example, the electronic devices 100 and 300.

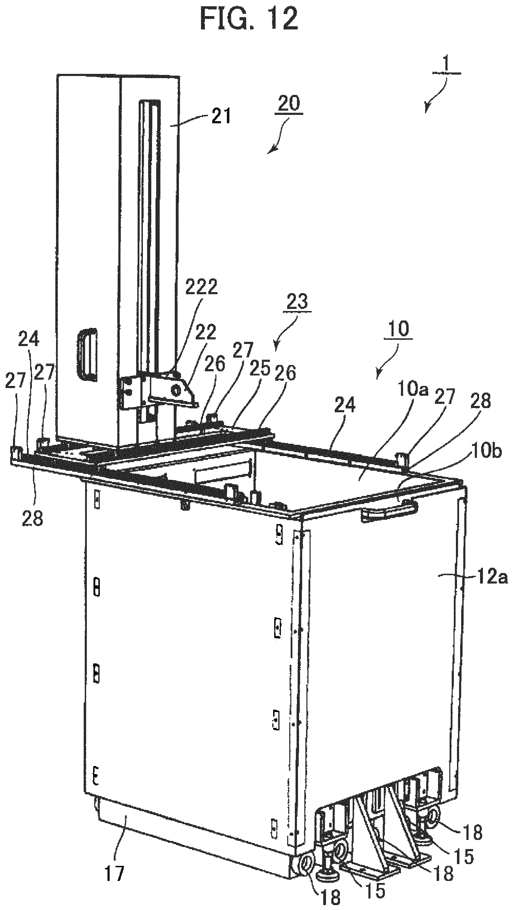

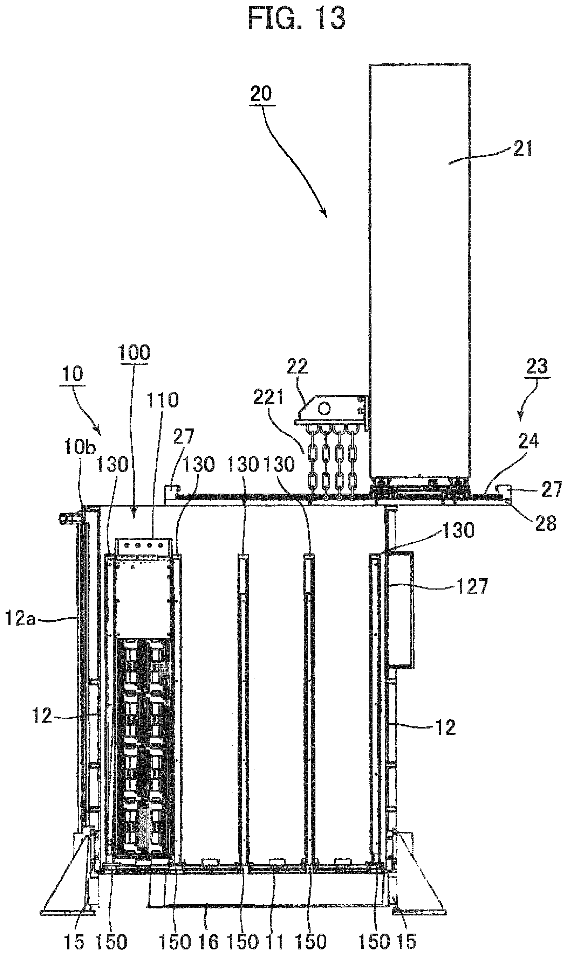

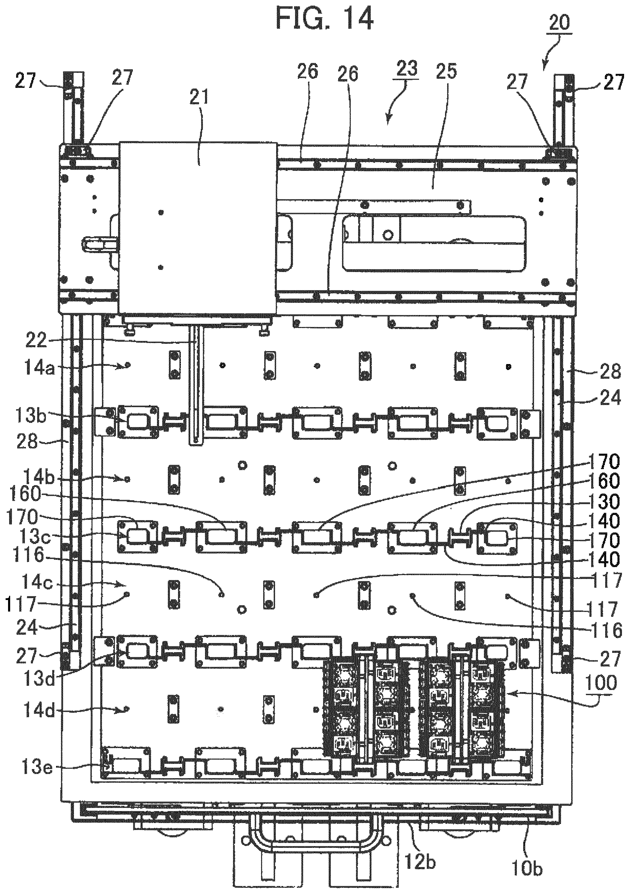

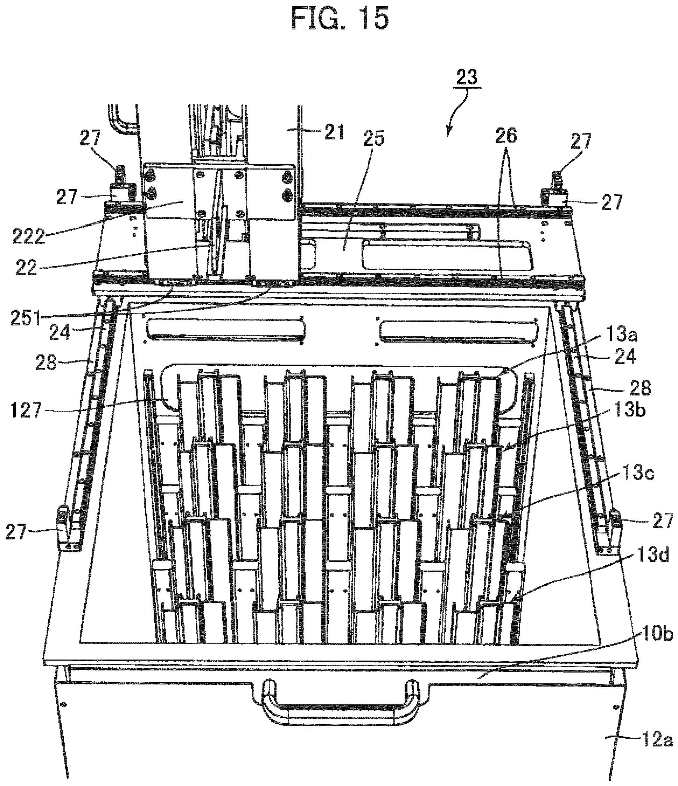

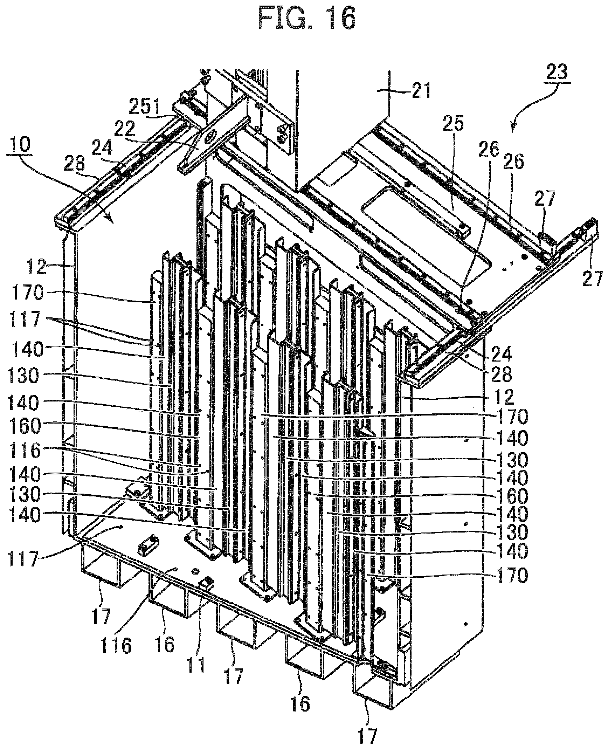

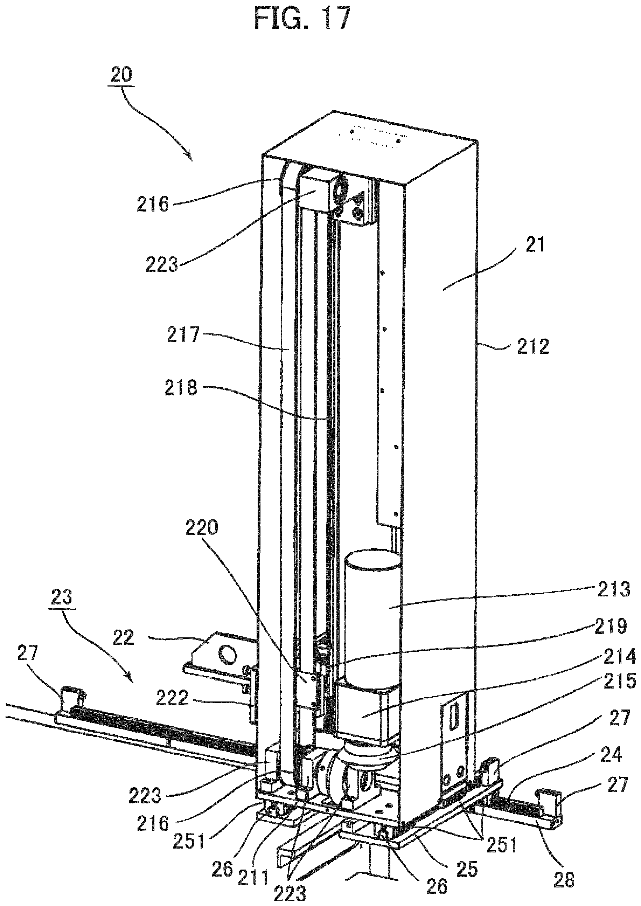

Referring to Figures 12 to 17, a liquid immersion cooling apparatus 1 according to an embodiment includes a cooling tank 10. An open space 10a is defined by a bottom wall 11 and side walls 12 of the cooling tank 10. Inner partitions 13a, 13b, 13c, 13d, 13e are laterally disposed in the cooling tank 10 so as to equally divide the open space 10a into four arrayed housing parts 14a, 14b, 14c, 14d. In the embodiment, four units of a vertically long electronic device 100 having the width approximately 1/4 of the longitudinal length of the open space 10a of the cooling tank 10 are housed in each of the housing parts 14a, 14b, 14c, 14d. That is, a total of sixteen units of the electronic device may be housed with high density.

A casing 12a is provided around the outer periphery of the side walls 12 of the cooling tank 10. The space is formed between the side wall 12 at the front side of the cooling tank 10 and the casing 12a. A top plate 10b for closing the open space 10a of the cooling tank 10 may be housed in the space. Upon maintenance work for the liquid immersion cooling apparatus 1, the top plate 10b is kept housed in the space. Upon operation of the liquid immersion cooling apparatus 1, the top plate 10b is taken out from the space to cover the opening of the cooling tank 10 so that the open space 10a is closed.

The coolant (not shown) is filled in the cooling tank 10 up to the liquid surface (not shown) sufficient to immerse the entire body of the electronic device 100. It is preferable to use a fluorine based inert liquid formed of the complete fluoride well known as "Fluorinert (trademark of 3M Company) FC-72" (boiling point: 56°C), "Fluorinert FC-770" (boiling point: 95°C), "Fluorinert FC-3283" (boiling point 128°C), "Fluorinert FC-40" (boiling point: 155°C), "Fluorinert FC-43" (boiling point: 174°C), all of which are products of 3M Company. However, the arbitrary coolant may be used in a nonrestrictive way. The use of Fluorinert FC-40 and Fluorinert FC-43 each having the boiling point higher than 150°C, which hardly evaporates is advantageous for keeping the liquid level height in the cooling tank 10 for a long period of time.

Disposed below the bottom wall 11 of the cooling tank 10 are a plurality of inflow headers 16 each having inlets 15 for the coolant at both ends, and a plurality of outflow headers 17 each having outlets 18 for the coolant at both ends. Those inflow headers 16 and the outflow headers 17 are alternately arranged in the lateral direction with respect to the bottom wall 11 of the cooling tank 10.

Each of the inner partitions 13a, 13b, 13c, 13d, 13e includes a plurality of inflow pipes 160, and a plurality of outflow pipes 170 both penetrating through the bottom wall 11 via bottom openings 150, and extending to the level around the liquid surface of the coolant, and a plurality of board retainers 130 for retaining an edge of the base board 110 of the electronic device 100. In the embodiment, the inflow pipes 160 and the outflow pipes 170 are alternately disposed via support spacers 140 at left and right sides of the board retainers 130 each having one end fixed to the bottom wall 11. In each of the housing parts 14a, 14b, 14c, 14d, a recess part formed by a pair of board retainers 130 longitudinally facing each other in the cooling tank 10 is designed to mechanically hold the edge of the base board 110 of the electronic device 100 at both sides. For the mechanical holding operation, it is possible to attach a rod-like support to the edge of the base board 110 so as to be fit with the width of the recess part formed in the board retainers 130.

Each of the inflow pipe 160 and the outflow pipe 170 has a rectangular cross section, for example. The inflow pipe 160 has a plurality of small holes as inflow openings 116 along the longitudinal direction of the inflow pipe 160. Likewise, the outflow pipe 170 has a plurality of small holes as outflow openings 117 along the longitudinal direction of the outflow pipe 170. The inflow openings 116 are formed in front and back surfaces of the inflow pipe 160. Likewise, the outflow openings 117 are formed in front and back surfaces of the outflow pipe 170.

Additionally, a plurality of small holes piercing through the bottom wall 11 are formed in bottom parts of the housing parts 14a, 14b, 14c, 14d as additional inflow openings 116 and outflow openings 117, respectively. Another outflow opening 127 is formed in the upper portion of the side wall 12 at the back side of the cooling tank 10. The outflow opening 127 formed in the side wall 12 at the back side corresponds to the outflow opening formed in the part around the liquid surface of the coolant.

In the embodiment, the circulation of the coolant when using the liquid immersion cooling apparatus 1 will be briefly described. The cold coolant which has been supplied from the inlets 15 at both ends to the inflow header 16 is partially discharged from the inflow openings 116 formed in the respective bottom parts of the housing parts 14a, 14b, 14c, 14d. The remaining coolant is supplied into the inflow pipes 160 through the bottom openings 150. The coolant supplied into the inflow pipes 160 is discharged from the inflow openings 116 formed in the inflow pipes 160.

The coolant warmed by heat taken from the electronic devices 100 housed in the housing parts 14a, 14b, 14c, 14d passes through the outflow opening 127 formed in the side wall 12 at the back side of the cooling tank 10 at the height near the liquid surface, and flows out from the cooling tank 10. The warmed coolant is partially drawn into the outflow headers 17 from the outflow openings 117 formed in the bottom parts of the housing parts 14a, 14b, 14c, 14d. At the same time, the coolant passes through the outflow openings 117 formed in the outflow pipe 170, and the bottom openings 150 so as to be drawn into the outflow headers 17. The coolant drawn into the outflow headers 17 flows out from the cooling tank 10 while passing through the outlets 18.

The inflow openings 116 for the coolant are formed in the bottom parts or the side surfaces of the respective housing parts 14a, 14b, 14c, 14d, and the outflow opening 127 is formed around the liquid surface of the coolant. The above-described structure prevents stagnation of the coolant which has been warmed by the highly densely housed electronic devices 100 in the respective housing parts 14a, 14b, 14c, 14d so that the cooling efficiency is improved. The structure having the inflow pipe 160 with the inflow openings 116 and the outflow pipe 170 with the outflow openings 117 disposed at the left and right sides of each of the board retainers 130 alternately via the support spacers 140 is especially advantageous because of further enhanced effect of preventing the coolant stagnation.

Referring to the drawing, the detailed explanation will be made with respect to a lifting mechanism configured to lift and lower the vertically long electronic devices 100 which are highly densely housed in the cooling tank 10 from/into the housing parts 14a, 14b, 14c, 14d, respectively.

A lifting mechanism 20 includes an arm 22 configured to lift the electronic devices 100 from the housing parts 14a, 14b, 14c, 14d, and lower them into the housing parts 14a, 14b, 14c, 14d. The lifting mechanism 20 includes a tower 21 equipped with a guide 218 and a motive power source 213 for raising and lowering the arm 22, and a slide mechanism 23 attached to the cooling tank 10 for movably supporting the tower 21 relative to the cooling tank 10 in a horizontal plane located above the open space 10a. As the slide mechanism 23 is directly attached to the cooling tank 10, the stage does not have to be provided in the periphery of the installation surface of the cooling tank 10. The guide 218 and the motive power source 213 of the tower 21 allow the arm 22 to move up and down. This makes it possible to safely lift or lower the electronic devices housed with high density in the cooling tank without vibrating the arm forward, backward, leftward, and rightward during the lifting operation.

In the embodiment, the tower 21 includes a reducer 214 for reducing the rotating speed of a shaft of the motive power source 213 such as the servo motor, a gear 215 for converting the rotary motion of the shaft of the reducer 214 into the rotary motion of the shaft orthogonal to the shaft of the reducer 214, a pair of timing pulleys 216, and a timing belt 217. One of brackets 222 of the arm 22 is movably supported at the guide 218 disposed in the vertical direction (Z direction) via a guide roller 219. The other bracket 222 of the arm 22 is fixed to the timing belt 217 through a belt holder 220. The shaft of the gear 215 and the shaft of the timing pulley 216 are rotatably supported with bearing holders 223.

In the embodiment, the slide mechanism 23 includes a pair of longitudinal rails 24 disposed on top ends of the pair of side walls 12 positioned in the width direction of the cooling tank 10, a movable base 25 movably supported on the pair of longitudinal rails 24, and a pair of lateral rails 26 disposed on the movable base 25. The tower 21 is movably supported on the pair of lateral rails 26. Specifically, a plurality of guide rollers 251 attached to the lower part of the movable base 25 slide on the pair of longitudinal rails 24 so as to allow the longitudinal movement (Y direction) of the tower 21. The guide rollers 251 attached to a fixation base 211 at the bottom part of the tower 21 slide on the pair of lateral rails 26 to allow the lateral movement (X direction) of the tower 21.

Referring to the example shown in the drawing, a pair of supports 28 are used for placing the pair of longitudinal rails 24 on the top ends of the side walls 12 of the cooling tank 10. The support 28 is fixed to the top end of the side wail 12 so that one end of the support 28 projects rearward of the cooling tank 10 by the length substantially equal to the longitudinal length of the tower 21. The pair of longitudinal rails 24 are disposed on the thus projected pair of supports 28. Then the pair of longitudinal rails 24 have running ranges where the movable bases 25 are located rearwardly apart from the upper part of the open space 10a of the cooling tank 10 for allowing the electronic device 100 to be lifted from the housing part 14a that is the closest to the side wall 12 at the back surface side of the cooling tank 10, and to be lowered into the housing part 14a. The pair of supports 28 and the pair of longitudinal rails 24 are disposed so as to be located outside the width of the top plate 10b when it is disposed to cover the opening of the cooling tank 10. The above-described structure is designed so that those supports 28 and the longitudinal rails 24 do not interfere with covering of the open space 10a by the top plate 10b.

Stoppers 27 disposed near both ends of the pair of longitudinal rails 24 serve to restrict the range in which the tower 21 moves in the longitudinal direction (Y direction) of the cooling tank 10 in a horizontal plane located above the open space 10a. The stoppers 27 disposed near both ends of the pair of lateral rails 26 serve to restrict the movement of the tower 21 so that the range in which the tower 21 moves in the width direction (X direction) of the cooling tank 10 does not substantially exceed at least the width of the open space 10a. This ensures to prevent the fixation base 211 or a housing 212 of the tower 21 from extending over the width of the cooling tank 10 upon movement of the tower 21 in the width direction of the cooling tank 10. Although the plurality of liquid immersion cooling apparatuses are densely arranged, the above-described structure may prevent the interference between operation ranges of the lifting mechanisms of the adjacent liquid immersion cooling apparatuses.

The operation of the above-structured lifting mechanism 20 will be described. The tower 21 is horizontally moved with a handle at the side of the tower 21, and stopped at the position where the arm 22 is located just above the base board 110 of the electronic device 100 to be lifted. A controller (not shown) is operated to drive the motive power source 213 of the tower 21 so that the rotation of the shaft of the motive power source 213 is transferred to the timing pulley 216 via the gear 215 to lower the arm 22 to the lowermost part. In this state, tips of a pair of suspension fittings 221 attached to the lower part of the arm 22 are connected to a pair of holes formed in the top end of the base board 110 of the electronic device 100. Then the controller (not shown) is operated to transfer the reverse rotation of the shaft of the motive power source 213 of the tower 21 to the timing pulley 216 for lifting the arm 22. The electronic device 100 which is suspended with the arm 22 by the suspension fittings 221 is then lifted while having the base board 110 sliding in the board retainer 130. Upon raising of the arm 22 to the uppermost part, the electronic device 100 is brought into the suspended state while being completely taken out from the board retainers 130 of the housing part 14a, 14b, 14c, or 14d. In the above-described state, the tower 21 may be horizontally moved to carry out the maintenance work for the electronic device 100 as needed. After finishing the maintenance work, the controller (not shown) is operated again to lower the electronic device 100 into the housing part 14a, 14b, 14c, or 14d so as to be returned to the original position.

Meanwhile, the controller (not shown) is operated to stop driving the motive power source 213 of the tower 21 in the process of lifting or lowering the arm 22 so that the arm 22 is made stationary at the arbitrary height in the vertical direction of the tower 21. The electronic device 100 is suspended at the desired height while being held partially in the board retainer 130 of the housing part 14a, 14b, 14c, or 14d without being completely taken out therefrom. In the above-described state, it is possible to carry out the maintenance work for the electronic device 100. In the state where the electronic device 100 is suspended as well as in the stationary state at the arbitrary height in the direction vertical to the tower 21, the reducer 214 helps in preventing the downward load applied to the arm 22 from causing unintentional rotation of the shafts of the timing pulley 216 and the motive power source 213.

In the above embodiment, an example of the single cooling tank has been explained. However, it is possible to employ a plurality of cooling tanks adjacently arranged in the lateral direction. In this case, at least one lifting mechanism may be shared by the adjacently disposed cooling tanks. Specifically, the at least one lifting mechanism may be configured to include the tower having the guide and the motive power source for raising and lowering the arm, the slide mechanism which is attached to the adjacent cooling tank for movably supporting the tower relative to the adjacent cooling tank in a horizontal plane located above the open space, and the stoppers for restricting movement of the tower so that the tower movement range in the width direction of the adjacent cooling tank does not substantially exceed the distance between the side walls separated farthest in the lateral direction among those for forming the open space between the adjacent cooling tanks.

In the case of the cooling tanks adjacently arranged in the lateral direction, it is preferable that the slide mechanism includes the pair of longitudinal rails disposed on top ends of the pair of side walls located in the width direction of the respective cooling tanks, the movable bases movably supported on the pair of longitudinal rails, and the pair of lateral rails disposed on the movable bases. Preferably, the tower is movably supported on the pair of lateral rails. The width of the movable base may be substantially the same as that of the single cooling tank, or the same as the overall width of the adjacently arranged cooling tanks. If the movable base has the width substantially the same as that of the single cooling tank, the pair of lateral rails for one of the adjacent cooling tanks may be linked to the pair of lateral rails for the other cooling tank using the appropriate linkage member. This makes it possible to move the tower on one pair of lateral rails onto the other pair of lateral rails so that the single tower is shared by the adjacently arranged cooling tanks. If the movable base has the width substantially the same as the overall width of the plurality of adjacently arranged cooling tanks, the length of the pair of lateral rails may be set to the overall width of the adjacently arranged cooling tanks. Therefore, the linkage member for linking the pairs of lateral rails is not required.

In the above embodiment, the manual movement of the tower 21 in the horizontal plane has been explained as an example. It is possible to add a motive power source for running the movable base 25 on the longitudinal rail 24, and another motive power source for running the tower 21 including the fixation base 211 on the lateral rail 26 to the lifting mechanism so as to move the tower 21 by operating the controller (not shown). It is possible to employ the electric motive power source such as the servo motor for those additional motive power sources,

In the case of movement of the tower 21 in the horizontal plane by adding the electric motive power sources, it is possible to replace the mechanical stoppers 27 as shown in the drawing for physically interrupting the movement of the tower 21 with the movement restriction mechanism through software. In the specification, the stopper may include both the mechanical stopper and the movement restriction mechanism through software.

The liquid immersion cooling apparatus according to the embodiment ensures to safely lift or lower the electronic device housed in the cooling tank with high density without requiring the stage in the periphery of the installation surface of the cooling tank. Additionally, dense arrangement of a plurality of liquid immersion cooling apparatuses allows prevention of mutual interference between the movement ranges of the lifting mechanisms of adjacent liquid immersion cooling apparatuses,

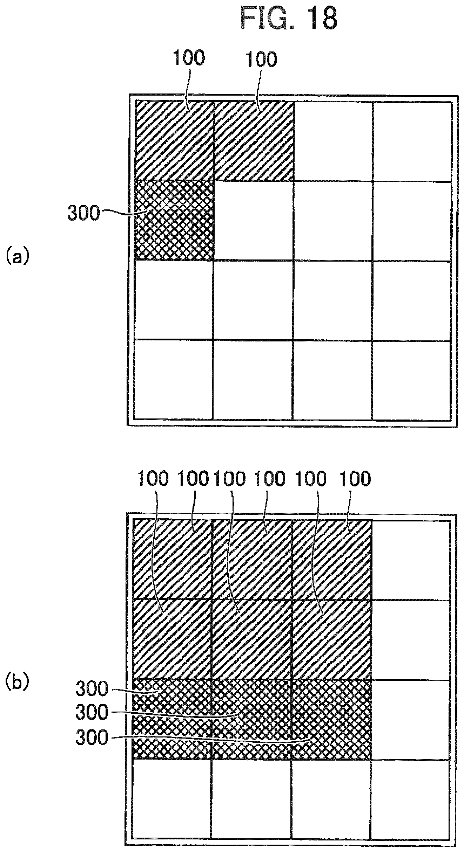

As described above, in the embodiment, it is possible to house a plurality of different types of electronic devices including the electronic devices 100 and 300, for example, in the plurality of housing parts in the cooling tank without being limited to the case where the electronic devices of the single type are housed. In other words, a plurality of different types of electronic devices include one or more first electronic devices each configured to mainly execute arithmetic operations through a plurality of processors, and one or more second electronic devices each configured to mainly store data through a plurality of storage units. One or more arbitrary numbers of the first electronic devices and one or more arbitrary numbers of the second electronic devices are housed in the respective housing parts of the cooling apparatus separately so that the cooling system constitutes the computer with desired calculation capacity and desired storage capacity. Referring to the schematic view in Figure 18, specifically, Figure 18(a), 2 units of the electronic device 100 and 1 unit of the electronic device 300 may be housed in 3 of 16 housing parts of the liquid immersion cooling apparatus 1 to constitute the computer. Referring to Figure 18(b), 6 units of the electronic device 100 and 3 units of the electronic device 300 may be housed in 9 housing parts to constitute the computer. The electronic device 100 corresponds to the first electronic device in which the arithmetic operation is mainly executed by the processors. The electronic device 300 corresponds to the second electronic device in which data storage is mainly executed by the storage units.

As described above, arbitrary combination of the first and the second electronic devices ensures to constitute the computer with desired calculation capacity and desired storage capacity. Therefore, it is possible to provide the configurable cooling system.

### Industrial Applicability

The present invention is widely applicable to electronic devices mounted with ultra-high density for liquid immersion cooling. Reference Signs List

1: liquid immersion cooling apparatus,
10: cooling tank,
10a: open space,
10b: top plate,
11: bottom wall,
12: side wall,
12a: casing,
100, 300: electronic device,
110, 310: base board,
111: suspension fitting hole,
112: flow channel,
120, 320: substrate group
121, 321: first circuit board,
122, 322: second circuit board,
123, 323: third circuit board,
124a, 124b, 124c, 124d: processor,
125: main memory,
126a, 126b, 126c, 126d: socket,
127a, 127b, 127c, 127d: voltage conversion circuit,
128, 138: spacer,
129, 139: screw,
130: board retainer,
131: first connector,
132, 332: second connector,
133, 333: third connector,
134: slot,
135, 335: power unit,
136, 336: network cable socket,
137: bottom hole,
140: support spacer,
13a, 13b, 13c, 13d, 13e: inner partition,
14a, 14b, 14c, 14d: housing part,
15: inlet,
150: bottom opening,
16: inflow header,
116: inflow opening,
160: inflow pipe,
17: outflow header,
117, 127: outflow opening,
170: outflow pipe,
18: outlet,
20: lifting mechanism,
21: tower,
211: fixation base,
212: housing,
213: motive power source,
214: reducer,
215: gear,
216: timing pulley,
217: timing belt,
218: guide,
219: guide roller,
220: belt holder,
22: arm,
221: suspension fitting,
222: bracket,
223: bearing holder,
23: slide mechanism,
24: longitudinal rail (Y direction),
25: movable base,
251: guide roller,
26: lateral rail (X direction),
27: stopper,
28: support,
311: primary member,
312: secondary member,
313: cut,
314: pawl,
315, 316: support plate,
3311a, 3311b: signal connector,
3312a, 3312b: power connector,
340: backplane,
340a, 340b: backplane unit,
341: slit,
351, 451, 551: storage substrate,
352, 452, 452a, 452b, 552, 552a, 552b: flash storage unit,
353: flash storage connector,
354, 454, 554: fastener,
355, 455, 555: expander,
360: storage connector,
361, 461, 561: storage connector plug,
4511, 5511: groove,
453a, 553a: flash storage connector (high),
453b, 553b: flash storage connector (low)

## Claims

1. A cooling apparatus (1) including an electronic device (100; 300) that is immersed in a liquid coolant filled in the cooling apparatus, and directly cooled, the electronic device (100; 300) being configured to be housed in a housing part of the cooling apparatus, the electronic device (100; 300) comprising:
a base board (110; 310);
a plurality of storage substrates (351; 451; 551) to be arranged on at least one surface of the base board (110; 310);
a backplane (340) including a plurality of connectors (360) for electric connection of the respective storage (351; 451; 551) substrates, the backplane (340) being mounted orthogonally onto the at least one surface of the base board (110; 310); and
a plurality of flash storage units (352; 452, 452a, 452b, 552, 552a, 552b) mounted on the respective storage substrates (351; 451; 551), wherein the flash storage units (352; 452, 452a, 452b, 552, 552a, 552b) each having a rectangular shape are arranged on a surface parallel to at least one surface of each of the storage substrates (351; 451; 551) so as to be adjacent one another in a width or a length direction, or in both the width and the length directions of the rectangular-shaped flash storage unit (352; 452, 452a, 452b, 552, 552a, 552b);
**characterized in that**
the base board (110; 310) includes a primary member (311) and a secondary member (312);
the primary member (311) includes a plurality of cuts (313) each formed in a width direction for fixing a plurality of support plates(315, 316) each having grooves that support the storage substrates (351; 451; 551) to the primary member (311);
the secondary member (312) includes a plurality of pawls (314) which are inserted into a plurality of slits (341) formed in the backplane (340), respectively, and fixed to the primary member (311); and
the support plates (315, 316) include holes for passage of the liquid coolant.

2. The cooling apparatus (1) according to claim 1, wherein the cooling apparatus includes a cooling tank (10) with an open space defined by a bottom wall (11) and side walls (12), arranged housing parts formed by dividing the open space using a plurality of internal partition walls (13a, 13b, 13c, 13d) in the cooling tank (10), and an inflow opening (116) and an outflow opening (117, 127) for the liquid coolant, the inflow opening (116) being formed in a bottom part or a side surface of each of the housing parts, and the outflow opening (117,127) being formed around a surface of the liquid coolant circulating in the respective housing parts.

3. The cooling apparatus (1) according to claim 1 or 2, wherein the flash storage unit (352; 452, 452a, 452b; 552, 552a, 552b) is an M.2 SSD or an mSATA SSD.

4. The cooling apparatus (1) according to claim 1 or 2, wherein:
a plurality of flash storage connectors (453a, 453b; 553a, 553b) are arranged on the one surface of each of the storage substrate 4(351; 451; 551); and
each electric contact of the flash storage units (352; 452, 452a, 452b; 552, 552a, 552b) is inserted into one of the flash storage connectors (453a, 453b; 553a, 553b).

5. The cooling apparatus (1) according to claim 1 or 2, wherein:
the storage substrates (351; 451; 551) are further arranged on a surface opposite the one surface of the base board (110; 310); and
the backplane (340) further includes a plurality of connectors for electric connection of the storage substrates (351; 451; 551) arranged on the surface opposite the one surface of the base board (110; 310).

## Patentansprüche

1. Kühlvorrichtung (1) mit einer elektronischen Einrichtung (100; 300), die in ein flüssiges Kühlmittel eingetaucht ist, das in die Kühlvorrichtung gefüllt ist, und direkt gekühlt wird, wobei die elektronische Einrichtung (100; 300) so konfiguriert ist, dass sie in einem Gehäuseteil der Kühlvorrichtung untergebracht ist, wobei die elektronische Einrichtung (100; 300) umfasst:
eine Basisplatte (110; 310);
eine Vielzahl von Speichersubstraten (351; 451; 551), die auf mindestens einer Oberfläche der Basisplatte (110; 310) anzuordnen sind;
eine Rückwand (340) mit einer Vielzahl von Anschlüssen (360) zum elektrischen Anschließen der jeweiligen Speichersubstrate (351; 451; 551), wobei die Rückwand (340) orthogonal auf der mindestens einen Oberfläche der Basisplatte (110; 310) montiert ist; und
eine Vielzahl von Flash-Speichereinheiten (352; 452, 452a, 452b, 552, 552a, 552b), die auf den jeweiligen Speichersubstraten (351; 451; 551) angebracht sind, wobei die Flash-Speichereinheiten (352; 452, 452a, 452b, 552, 552a, 552b), die jeweils eine rechteckige Form aufweisen, auf einer Oberfläche parallel zu mindestens einer Oberfläche jedes der Speichersubstrate (351; 451; 551) auf einer Fläche parallel zu mindestens einer Fläche jedes der Speichersubstrate (351; 451; 551) so angeordnet sind, dass sie in einer Breiten- oder einer Längsrichtung oder sowohl in der Breiten- als auch in der Längsrichtung der rechteckigen Flash-Speichereinheit (352; 452, 452a, 452b, 552, 552a, 552b) nebeneinander liegen; **dadurch gekennzeichnet, dass**
die Basisplatte (110; 310) ein primäres Element (311) und ein sekundäres Element (312) aufweist;
das primäre Element (311) eine Vielzahl von Einschnitten (313) enthält, die jeweils in einer Breitenrichtung ausgebildet sind, um eine Vielzahl von Trägerplatten (315, 316) zu befestigen, die jeweils Nuten aufweisen, die die Speichersubstrate (351; 451; 551) an dem primären Element (311) tragen;
das sekundäre Element (312) eine Vielzahl von Sperrklinken (314) aufweist, die in eine Vielzahl von Schlitzen (341) eingesetzt sind, die in der Rückwand (340) ausgebildet sind, und die an dem primären Element (311) befestigt sind; und
die Trägerplatten (315, 316) Löcher für den Durchgang des flüssigen Kühlmittels aufweisen.

2. Kühlvorrichtung (1) nach Anspruch 1, wobei die Kühlvorrichtung einen Kühltank (10) mit einem offenen Raum (10a) umfasst, der durch eine Bodenwand (11) und Seitenwände (12) definiert ist, wobei Gehäuseteile angeordnet sind, die durch Unterteilung des offenen Raums (10a) unter Verwendung einer Vielzahl von inneren Trennwänden (13a, 13b, 13c, 13d) in dem Kühltank (10) gebildet sind, und eine Einlassöffnung (116) und eine Auslassöffnung (117, 127) für das flüssige Kühlmittel, wobei die Einlassöffnung (116) in einem Bodenteil oder einer Seitenfläche jedes der Gehäuseteile gebildet ist und die Auslassöffnung (117, 127) um eine Oberfläche des flüssigen Kühlmittels, das in den jeweiligen Gehäuseteilen zirkuliert, gebildet ist.

3. Kühlvorrichtung (1) nach Anspruch 1 oder 2, wobei die Flash-Speichereinheit (352; 452, 452a, 452b; 552, 552a, 552b) eine M.2 SSD oder eine mSATA SSD ist.

4. Kühlvorrichtung (1) nach Anspruch 1 oder 2, wobei:
eine Vielzahl von Flash-Speicheranschlüssen (453a, 453b; 553a, 553b) auf der einen Oberfläche jedes der Speichersubstrate 4 (351; 451; 551) angeordnet sind; und
jeder elektrische Kontakt der Flash-Speichereinheiten (352; 452, 452a, 452b; 552, 552a, 552b) in einen der Flash-Speicheranschlüsse (453a, 453b; 553a, 553b) eingesetzt ist.

5. Kühlvorrichtung (1) nach Anspruch 1 oder 2, wobei:
die Speichersubstrate (351; 451; 551) ferner auf einer Oberfläche angeordnet sind, die der einen Oberfläche der Basisplatte (110; 310) gegenüberliegt; und
die Rückwand (340) ferner eine Vielzahl von Anschlüssen zum elektrischen Anschließen der Speichersubstrate (351; 451; 551) enthält, die auf der Oberfläche gegenüber der einen Oberfläche der Basisplatte (110; 310) angeordnet sind.

## Revendications

1. Appareil de refroidissement (1) comprenant un dispositif électronique (100 ; 300) qui est immergé dans une solution de refroidissement liquide remplie dans l'appareil de refroidissement, et refroidi directement, le dispositif électronique (100 ; 300) étant configuré pour être reçu dans une partie formant logement de l'appareil de refroidissement, le dispositif électronique (100 ; 300) comportant :
une plaque de base (110 ; 310) ;
une pluralité de substrats de stockage (351 ; 451 ; 551) destinés à être agencés sur au moins une surface de la plaque de base (110 ; 310) ;
un fond de panier (340) comprenant une pluralité de connecteurs (360) à des fins de connexion électrique des substrats de stockage respectifs (351 ; 451; 551), le fond de panier (340) étant monté de manière orthogonale sur ladite au moins une surface de la plaque de base (110 ; 310) ; et
une pluralité d'unités de stockage de mémoire flash (352 ; 452, 452a, 452b, 552, 552a, 552b) montées sur les substrats de stockage respectifs (351 ; 451 ; 551), dans lequel les unités de stockage de mémoire flash (352 ; 452, 452a, 452b, 552, 552a, 552b) ayant chacune une forme rectangulaire sont agencées sur une surface parallèle à au moins une surface de chacun des substrats de stockage (351 ; 451 ; 551) de manière à être adjacentes à une autre dans une direction allant dans le sens de la largeur ou dans le sens de la longueur, ou dans les deux directions allant dans le sens de la largeur et dans le sens de la longueur de l'unité de stockage de mémoire flash de forme rectangulaire (352 ; 452, 452a, 452b, 552, 552a, 552b) ;
**caractérisé en ce que**
la plaque de base (110 ; 310) comprend un élément primaire (311) et un élément secondaire (312) ;
l'élément primaire (311) comprend une pluralité de découpes (313) qui sont, chacune, formées dans une direction allant dans le sens de la largeur pour fixer une pluralité de plaques de support (315, 316) ayant chacune des rainures qui supportent les substrats de stockage (351 ; 451 ; 551) sur l'élément primaire (311) ;
l'élément secondaire (312) comprend une pluralité de cliquets (314) qui sont insérés dans une pluralité de fentes (341) formées dans le fond de panier (340), respectivement, et qui sont fixés sur l'élément primaire (311) ; et
les plaques de support (315, 316) comprennent des trous pour le passage de la solution de refroidissement liquide.

2. Appareil de refroidissement (1) selon la revendication 1, dans lequel l'appareil de refroidissement comprend une cuve de refroidissement (10) avec un espace ouvert (10a) que définissent une paroi inférieure (11) et des parois latérales (12), des parties formant logement agencées étant formées en divisant l'espace ouvert (10a) en utilisant une pluralité de parois de séparation internes (13a, 13b, 13c, 13d) dans la cuve de refroidissement (10), et une ouverture d'entrée de flux (116) et une ouverture de sortie de flux (117, 127) pour la solution de refroidissement liquide, l'ouverture d'entrée de flux (116) étant formée dans une partie inférieure ou une surface latérale de chacune des parties formant logement, et l'ouverture de sortie de flux (117, 127) étant formée autour d'une surface de la solution de refroidissement liquide circulant dans les parties formant logement respectives.

3. Appareil de refroidissement (1) selon la revendication 1 ou la revendication 2, dans lequel l'unité de stockage de mémoire flash (352 ; 452, 452a, 452b ; 552, 552a, 552b) est un disque M.2 SSD ou un disque mSATA SSD.

4. Appareil de refroidissement (1) selon la revendication 1 ou la revendication 2, dans lequel :
une pluralité de connecteurs de stockage de mémoire flash (453a, 453b ; 553a, 553b) sont agencés sur ladite une surface de chacun des substrats de stockage 4(351 ; 451 ; 551) ; et
chaque contact électrique des unités de stockage de mémoire flash (352 ; 452, 452a, 452b ; 552, 552a, 552b) est inséré dans l'un des connecteurs de stockage de mémoire flash (453a, 453b ; 553a, 553b).

5. Appareil de refroidissement (1) selon la revendication 1 ou la revendication 2, dans lequel :
les substrats de stockage (351 ; 451 ; 551) sont par ailleurs agencés sur une surface opposée à ladite une surface de la plaque de base (110 ; 310) ; et
le fond de panier (340) comprend par ailleurs une pluralité de connecteurs à des fins de connexion électrique des substrats de stockage (351 ; 451 ; 551) agencés sur la surface opposée à ladite une surface de la plaque de base (110 ; 310).
